# EUROPEAN PATENT SPECIFICATION

(11) **EP 0 834 605 B1**
(45) Date of publication and mention of the grant of the patent: **12.12.2001**
(21) Application number: 97115850.6
(22) Date of filing: 11.09.1997
(51) Int. Cl.: C30B 15/00, C30B 29/32

(54) **Oxide single crystal and method of manufacturing thereof**
Oxid-Einkristall und Verfahren zu seiner Herstellung
Monocristal d'un oxyde et procédé de sa fabrication

(30) Priority: 02.10.1996 JP 28167996
(43) Date of publication of application: 08.04.1998
(73) Proprietor: MURATA MANUFACTURING CO., LTD., Nagaokakyo-shi Kyoto-fu 226 (JP)
(72) Inventor: Takagi, Hiroshi, Nagaokakyo-shi, Kyoto-fu (JP); Kumatoriva, Makoto, Nagaokakyo-shi, Kyoto-fu (JP); Fukuda, Tsuguo, Sendai-shi, Miyagi-ken (JP)
(74) Representative: Zinnecker, Armin, Dipl.-Ing.

(56) References cited:
- EP-A- 0 559 921
- RANDLES ET AL: "disordered oxide crystal hosts for diode pumped lasers" JOURNAL OF CRYSTAL GROWTH., vol. 128, no. 1/4, March 1993, AMSTERDAM NL, pages 1016-1020, XP000349498
- NOSENKO ET AL.: "laser materials on basis of disordered crystals with Ca3Ga2Ge4O14" JOURNAL DE PHYSIQUE, vol. 4, no. 4, April 1994, LES ULIS, FRANCE, pages 455-458, XP002051174
- NOSENKO ET AL.: "optical and epr spectroscopy of impurity manganese ions in disordered Ca3Ga2Ge4O14 single crystals" RADIATION EFFECTS AND DEFECTS IN SOLIDS, vol. 135, no. 1-4, 1995, LYON FRANCE, pages 55-60, XP002051175
- KAMINSKI: "Pure and Nd3+ doped Ca3Ga2GeO14 single crystals, their structure, optical, spectral luminescence, electromechanical properties, and simulated emission." PHYS.STATUS SOLIDI A, vol. 86, no. 1, 16 November 1984, BERLIN. DE, pages 345-362, XP002051176

## Description

### BACKGROUND OF THE INVENTION

### Technical Field of the Invention

The present invention relates to an oxide single crystal and a method of manufacturing thereof. More particularly, the oxide single crystal has the crystal structure of Ca₃Ga₂Ge₄O₁₄ and contains Ge as a constituent element and the method comprises the steps of preparing a melt of starting materials containing Ge, and growing said oxide crystal from said melt of starting materials in single-crystal growing atmosphere. The oxide single crystal is used as a material for piezoelectric devices (because of its piezoelectric properties) and a solid laser host material.

### Related Art of the Invention

Since the discovery of Ca₃Ga₂Ge₄O₁₄ compound by B. V. Mill et al., a number of compounds of the same structure have been found as the result of substitution of constituents with cations. Their examples are La₃Ga₅SiO₁₄, La₃Ga_{5.5}Nb_{0.5}O₁₄, La₃Ga_{5.5}Ta_{0.5}O₁₄, and La₃Ga₅ZrO₁₄ which are formed by substitution of Ca with La or substitution of Ge with Ga and Si, Ga and Nb, Ga and Ta, or Ga and Zr. They have been found to have electromechanical coupling coefficients greater than that of - quartz. They have also been found to have a crystal axis along which the temperature coefficient of freaquency is zero. For these reasons, they are regarded as a promising material for the piezoelectric devices of mobile communications equipment of next generation. The technology in this field has advanced to such an extent that a La₃Ga₅SiO₁₄ single crystals (an ingot having about 76 cm (3 inches) in diameter) can be produced easily by Czochralski method.

It is known that the La,Ga-based compound mentioned above is surpassed in electromechanical coupling coefficients by those Ca₃Ga₂Ge₄O₁₄ compounds in which the Ca site is replaced by an alkali metal ion or alkaline earth metal ion. Nevertheless, they are not yet available in the form of large single crystal because of many difficulties involved. For example, they have a melting point of 1300°C or above which exceeds the vaporizing point of GeO₂ as one of the starting materials. This leads to a product of poor quality due to its composition differing from that of the starting materials, cracking in the crystal, and gaseous impurity phases.

Randles et al discloses in "Disordered oxide crystal hosts for diode pumped lasers", published in journal of crystal growth, volume 128, No. 1-4, March 1993, Amsterdam, NL, pages 1016 - 1020, XP000349498 a method for growing oxide crystals having the features of the preamble of claim 1.

### SUMMARY OF THE INVENTION

It is in object of the present invention to provide an oxide single crystal of large size having the crystal structure of Ca₃Ga₂Ge₄O₁₄ and containing Ge as a constituent element and an improved method of manufacturing thereof.

This object is achieved with a method having the features of claim 1 and a single crystal having the features of claim 6.

Preferable embodiments form the subject matter of the respective subclaims.

Because GeO₂ begins to evaporate at 1250° C or above in air (in which the oxygen partial pressure is CC.2 x 10⁴ Pa (2 x 10 ⁻¹ atm)) and an oxide of Ca₃Ga₂Ge₄O₁₄ crystal structure containing Ge as a constituent element has a melting point higher than this temperature, the evaporation of GeO₂ from this oxide at its melting point is inevitable.

The present invention to cope with this situation is designed to grow the single crystal from a melt of the starting material containing GeO₂ in an excess amount which would make up for the evaporation loss of GeO_{2.} The excess amount is less than 1 wt% in view of the fact that the evaporation of GeO₂ from the melt of starting materials is less than 1wt% during crystal growth.

To suppress the evaporation of GeO₂, the present invention is also designed to grow the single crystal in an atmosphere in which the oxygen partial pressure is higher than that (2 × 10⁴ Pa (2 × 10⁻¹ atm)) of air.

The present invention produces the following effects.

Production of an oxide single crystal of large size having the crystal structure of Ca₃Ga₂Ge₄O₁₄ and containing Ge as a constituent element by growth from a melt of starting materials without change in composition due to evaporation loss of GeO₂ from the melt.

Suppression of evaporation of GeO₂.

Production of a high-quality oxide single crystal of large size having the crystal structure of Ca₃Ga₂Ge₄O₁₄ and containing Ge as a constituent element.

These and other objects of the invention will become more apparent in the detailed description and examples which follow.

### PREFERRED EMBODIMENTS OF THE INVENTION

The following two examples demonstrate methods for manufacturing Sr₃Ga₂Ge₄O₁₄ single crystals as an oxide single crystal which has the crystal structure of Ca₃Ga₂Ge₄O₁₄ and contains Ge as a constituent element.

### (Example 1)

SrCO₃, Ga₂O₃, and GeO₂ as starting materials were weighed in a molar ratio of 3:1:4. To them was further added 0.75 wt% of GeO₂. These components were mixed by dry process and then press-formed and placed in a platinum crucible being 50 mm in diameter, 50 mm high, and 1.5 mm wall thickness. With radio-frequency heating, a single crystal (20 mm in diameter) was grown by Czochralski method at a crystal pulling rate of 1 mm/hour. The atmosphere for crystal growth was oxygen (with the oxygen partial pressure being 2 × 10⁴ Pa (2 × 10⁻¹ atm)), and the crystal was turned continuously at a rate of 10 rpm during crystal pulling.

During crystal growth, evaporation of a small amount of GeO₄ from the melt of raw materials was noticed. Nevertheless, there was obtained a high-quality single crystal, 60 mm in length, free of bubbles and cracks. The results of powder X-ray diffractometry indicate that there exists only the single phase of Sr₃Ga₂Ge₄O₁₄ in the axis parallel to the direction of crystal pulling and that the crystal has an invariable lattice constant.

### (Example 2)

SrCO₃, Ga₂O₃, and GeO₂ as starting materials were weighed in a molar ratio of 3:1:4. These components were mixed by dry process and then press-formed and placed in a platinum crucible being 50 mm in diameter, 50 mm high, and 1.5 mm wall thickness. With radio-frequency heating, a single crystal (20 mm in diameter) was grown by Czochralski method at a crystal pulling rate of 1 mm/hour. The atmosphere for crystal growth was oxygen (with the oxygen partial pressure being 10⁵ Pa (1 atm)), and the crystal was rotated continuously at a rate of 10 rpm during crystal pulling.

During crystal growth, evaporation of a small amount of GeO₂ from the melt of raw materials was noticed. Nevertheless, there was obtained a high-quality single crystal, 60 mm long, free of bubbles and cracks. The results of powder X-ray diffractometry indicate that there exists only the single phase of Sr₃Ga₂Ge₄O₁₄ in the axis parallel to the direction of crystal pulling and that the crystal has an invariable lattice constant.

The crystal-growing atmosphere in Example 1 should preferably contain an inert gas such as argon and nitrogen.

Although the above-mentioned examples demonstrate Sr₃Ga₂Ge₄O₁₄ single crystals, the present invention also covers other oxide single crystals having the crystal structure of Ca₃Ga₂Ge₄O₁₄ and containing Ge as a constituent element in which the Ca site is replaced by an alkali metal ion or alkaline earth metal ion, for example.

## Claims

1. A method of manufacturing an oxide crystal having a crystal structure of Ca₃Ga₂Ge₄O₁₄ and containing Ge as a constituent element, comprising the steps of;
1) preparing a melt of starting materials containing GeO₂, and
2) growing said oxide crystal from said melt of starting materials in single-crystal growing atmosphere,
**characterized in that**
said starting materials contain GeO₂ in a stoichiometrically excess amount, and/or
said single-crystal growing atmosphere is a gas having an oxygen partial pressure greater than that (2 × 10⁴ Pa (2 × 10⁻¹ atm)) of air.

2. A method according to Claim 1, **characterized in that**
said starting materials contain GeO₂ in a stoichiometrically excess amount.

3. A method according to Claim 2, **characterized in that**
said starting materials contain GeO₂ in a stoichiometrically excess amount less than 1.0 wt%.

4. A method according to one of Claims 1 to 3, **characterized in that**
said single-crystal growing atmosphere is a gas having an oxygen partial pressure greater than that (2 × 10⁴ Pa (2 × 10⁻¹ atm)) of air.

5. A method according to Claim 4, **characterized in that**
said gas contain an inert gas.

6. An oxide single crystal obtainable by the method according to one of Claims 1 to 5.

7. An oxide single crystal according to Claim 6, **characterized in that**
a Ca site of Ca₃Ga₂Ge₄O₁₄ is replaced by an alkali metal ion or alkaline earth metal ion.

8. An oxide single crystal according to Claim 7, **characterized in that**
said oxide single crystal is Sr₃Ga₂Ge₄O₁₄.

## Patentansprüche

1. Verfahren zur Herstellung eines Oxidkristalls mit der Kristallstruktur Ca₃Ga₂Ge₄O₁₄, der Ge als einen Bestandteil enthält, umfassend die folgenden Schritte:
1) Herstellen einer Schmelze der Ausgangsstoffe, umfassend GeO₂, und
2) Züchten des Oxidkristalls aus der Schmelze der Ausgangsstoffe in Einkristall-Zuchtatmosphäre,
**dadurch gekennzeichnet, dass**
die Ausgangsstoffe GeO₂ in einer stöchiometrischen Überschussmenge enthalten und/oder die Einkristall-Zuchtatmosphäre in einem Gas mit einem Sauerstoff-Partialdruck größer dem von Luft (2 x 10⁴ Pa(2 x 10⁻¹ atm)) besteht.

2. Verfahren nach Anspruch 1, **dadurch gekennzeichnet, dass** die Ausgangsstoffe GeO₂ in einer stöchiometrischen Überschussmenge enthalten.

3. Verfahren nach Anspruch 2, **dadurch gekennzeichnet, dass** die Ausgangsstoffe GeO₂ in einer stöchiometrischen Überschussmenge von weniger als 1,0 Gew.-% enthalten.

4. Verfahren nach einem der Ansprüche 1 bis 3, **dadurch gekennzeichnet, dass** die Einkristall-Zuchtatmosphäre in einem Gas mit einem Sauerstoff-Partialdruck größer dem von Luft (2 x 10⁴ Pa(2 x 10⁻¹ atm)) besteht.

5. Verfahren nach Anspruch 4, **dadurch gekennzeichnet, dass** das Gas ein Inertgas enthält.

6. Oxideinkristall, herstellbar mittels des Verfahrens nach einem der Ansprüche 1 bis 5.

7. Oxideinkristall nach Anspruch 6, **dadurch gekennzeichnet, dass** eine Ca-Stelle von Ca₃Ga₂Ge₄O₁₄ durch ein Alkalimetallion oder Erdalkalimetallion ersetzt ist.

8. Oxideinkristall nach Anspruch 7, **dadurch gekennzeichnet, dass** der Oxideinkristall Sr₃Ga₂Ge₄O₁₄ ist.

## Revendications

1. Procédé de fabrication d'un cristal d'oxyde présentant une structure cristalline Ca₃Ga₂Ge₄O₁₄ et contenant du Ge en tant qu'élément constitutif, comprenant les étapes de :
1) préparation d'un bain de fusion de matériau de départ contenant du GeO₂ ; et
2) croissance dudit cristal d'oxyde à partir dudit bain de fusion de matériau de départ dans une atmosphère de croissance de monocristal,
**caractérisé en ce que** :
lesdits matériaux de départ contiennent du GeO₂ selon une quantité stoechiométriquement en excès et/ou ladite atmosphère de croissance de monocristal est un gaz qui présente une pression partielle d'oxygène supérieure à celle (2x10⁴ Pa (2x10⁻¹ atmosphère)) de l'air.

2. Procédé selon la revendication 1, **caractérisé en ce que** :
lesdits matériaux de départ contiennent du GeO₂ selon une quantité stoechiométriquement en excès.

3. Procédé selon la revendication 2, **caractérisé en ce que** lesdits matériaux de départ contiennent du GeO₂ selon une quantité stoechiométriquement en excès inférieure à 1,0% en poids.

4. Procédé selon l'une quelconque des revendications 1 à 3, **caractérisé en ce que** ladite atmosphère de croissance de monocristal est un gaz qui présente une pression partielle d'oxygène supérieure à celle (2x10⁴ Pa (2x10⁻¹ atmosphère)) de l'air.

5. Procédé selon la revendication 4, **caractérisé en ce que** ledit gaz contient un gaz inerte.

6. Monocristal d'oxyde pouvant être obtenu au moyen du procédé selon l'une quelconque des revendications 1 à 5.

7. Monocristal d'oxyde selon la revendication 6, **caractérisé en ce qu'**un site Ca du Ca₃Ga₂Ge₄O₁₄ est remplacé par un ion de métal alcalin ou par ion de métal des terres alcalines.

8. Monocristal d'oxyde selon la revendication 7, **caractérisé en ce que** ledit monocristal d'oxyde est du Sr₃Ga₂Ge₄O₁₄.
